# EUROPEAN PATENT APPLICATION

(11) **EP 4 435 559 A1**
(43) Date of publication of application: **25.09.2024**
(21) Application number: 24163098.7
(22) Date of filing: 13.03.2024
(51) Int. Cl.: G06F 1/18, H05K 7/14, H02J 9/06, H02B 1/36, H02B 11/133

(54) **BACKFEED PROTECTION SYSTEMS AND METHODS OF ENGAGING POWER DISTRIBUTION ELEMENTS**

(30) Priority: 20.03.2023 US 202363453358 P; 06.03.2024 US 202418597043
(71) Applicant: Schneider Electric IT Corporation, Foxboro, MA 02035 (US)
(72) Inventor: ANDERSEN, Claus Aabjerg, ANDOVER, 01810 (US)
(74) Representative: Plasseraud IP

(57) **Abstract**

A backfeed protection system includes a casing and a moving plate assembly supported by the casing and configured to move with respect to the casing. The moving plate assembly includes at least one electrical contact configured to releasably engage a power distribution element. The backfeed protection system further includes an actuator secured to the casing and the moving plate assembly. The actuator is configured to move the moving plate assembly with respect to the casing between an engaged position in which the at least one electrical contact is engaged with the power distribution element and a disengaged position in which the at least one electrical contact is disengaged from the power distribution unit.

## Description

### BACKGROUND OF DISCLOSURE

Uninterruptible power supply (UPS) systems are typically equipped with backfeed protection to prevent or otherwise mitigate arc flash incidents. Standards requiring backfeed protection are stated in UL1778 (standard for America/Canada) and IEC 62040 (standard for rest of world).

The purpose of backfeed protection is to protect an operator when performing repair work upstream of the UPS. Proper preparation of the work typically requires that the operator de-energize the system with lock-out/tag-out before repair work can start to prevent the operator from being exposed to unwanted voltage. The operator may not know or be aware that a UPS is installed. The UPS has batteries and there may be a risk that the UPS could create voltage that is fed backwards in the installation (imagine removing the wall plug before repairing the lamp and then receiving an electrical shock from a battery in the bulb).

While backfeed protection may be required "in the system," the implementation of such backfeed protection can be either internal or external. Embodiments of the present disclosure provide benefits from both internal backfeed protection and external backfeed protection.

In recent years, much increased focus is paid to the risk associated with the insertion or removal of modules in a system that is powered on and energized.

In larger systems, an incident energy of a static bypass module prohibits the insertion of the module without powering down beforehand.

Embodiments of a backfeed protection system of the present disclosure make it possible to create a setup where the static bypass module is automated to make the connection.

### BRIEF DESCRIPTION OF DRAWINGS

The accompanying drawings are not intended to be drawn to scale. In the drawings, each identical or nearly identical component that is illustrated with various figures, are represented by a line numeral. For purposes of clarity, not every component may be labeled in every drawing. In the drawings:
FIG. 1 is a perspective view of a backfeed protection system of an embodiment of the present disclosure;
FIG. 2 is a perspective view of an example power module;
FIG. 3 is a perspective view of an example frame of the backfeed protection system;
FIG. 4 is a perspective view of an example outside casing of the backfeed protection system;
FIG. 5 is a perspective view of an example moving plate assembly of the backfeed protection system, the moving plate assembly including several thyristor assemblies;
FIG. 6A is a perspective view of an example modular locking switch of the backfeed protection system;
FIG. 6B is a perspective view of an example modular locking switch in a locked position;
FIG. 6C is a perspective view of an example modular locking switch in an unlocked position;
FIG. 7 is a perspective view of an example thyristor assembly having two jaws configured to engage busbars;
FIG. 8A is a perspective view of an example linear actuator or motor in a retracted position;
FIG. 8B is a perspective view of an example linear actuator in an extended position;
FIGS. 9 and 10 are perspective and top plan views of an example backfeed protection system, respectively, illustrating the backfeed protection system in a service or disengaged position;
FIGS. 11 and 12 are perspective and top plan views of an example backfeed protection system, respectively, illustrating the backfeed protection system in a ready position;
FIGS. 13 and 14 are perspective and top plan views of an example backfeed protection system, respectively, illustrating the backfeed protection system in an engaged position;
FIG. 15 is a top plan view of an example backfeed protection system illustrating the backfeed protection system in one fault scenario; and
FIG. 16 is a top plan view of an example backfeed protection system illustrating the backfeed protection system in another fault scenario.

### DETAILED DESCRIPTION

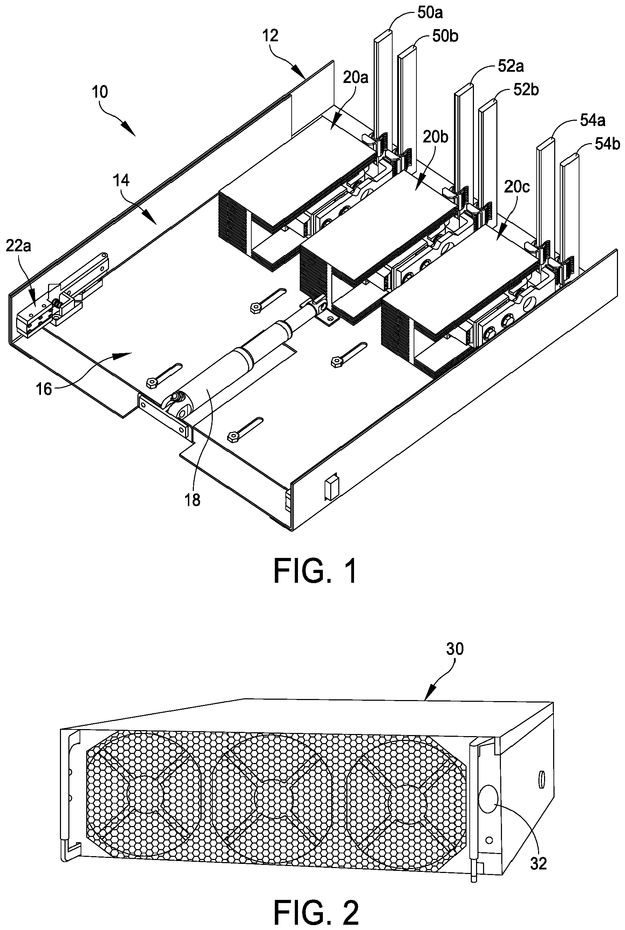

Referring to FIG. 1, a backfeed protection system of embodiments of the present disclosure is generally indicated at 10. The backfeed protection system 10 is configured to provide positive engagement and disengagement of jaws associated with thyristor assemblies or modules with busbars, which are sometimes referred to herein as power distribution elements. In one embodiment, the backfeed protection system 10 includes a frame, generally indicated at 12, which provides a structure to suspend the components of the backfeed protection system. In an implemented solution, the frame is bolted or riveted to the four corner pillars (not shown) within a support structure, such as an equipment rack. The backfeed protection system 10 further includes an outside casing, generally indicated at 14, which provides a support of the operatable components of the backfeed protection system that is removable from the frame 12. In animplemented solution, the outside casing 14 is completed with a top lid or cover and fans. The backfeed protection system 10 further includes a moving plate assembly, generally indicated at 16, which is configured to move with respect to the outside casing 14 to achieve a front/back transversal movement. The moving plate assembly 16 is configured to support several thyristor assemblies, each having electrical contacts, e.g., jaws, configured to releasably connect to busbars. The backfeed protection system 10 further includes a linear motor, indicated at 18, which is secured to the outside casing 14 and to the moving plate assembly 16 to drive the front/back transversal movement of the moving plate assembly. And finally, the backfeed protection system further includes several thyristor assemblies, generally indicated at 20a, 20b, 20c, which is rigidly mounted on the moving plate assembly 16, and one or more modular locking switches, generally indicated at 22a, 22b, which are configured to lock the outside casing 16 to the frame 12 and to control the withdrawal of the outside casing from the frame.

Referring to FIG. 2, an assembled power module is generally indicated at 30. The power module 30 includes a top cover that encloses some of the components described above including the outside casing 14, the moving plate assembly 16, the linear motor 18, the thyristor assemblies 20a, 20b, 20c and the modular locking switches 22a, 22b. The power module 30 includes a press button 32, which can be used to insert or push out the power module. In operation, a user depresses the press button 32 to remove the power module from the frame 12 of the equipment rack.

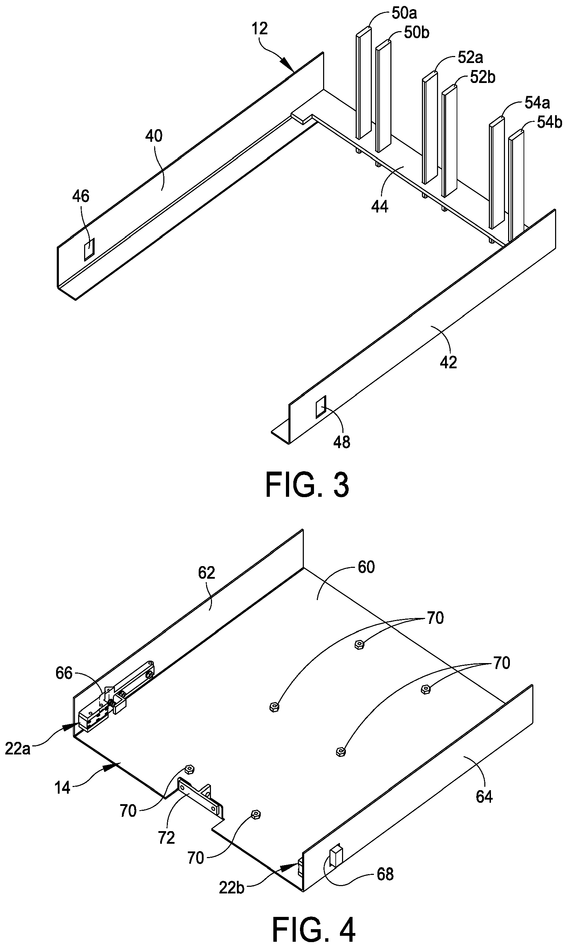

Referring to FIG. 3, the frame 12 includes a first side frame member 40 and a second side frame member 42, which is spaced from and parallel to the first side frame member. As shown, each side frame member 40, 42 may be constructed from angle iron that form shelves designed to mechanically support the power module, e.g., power module 30. The frame 12 further includes an end frame member 44 that connects ends of the first and second side frame members 40, 42. In one embodiment, the first and second side frame members 40, 42 may be fabricated from a conducting material, such as steel, and the end frame member 44 may be fabricated from an insulating material, such as epoxy or plastic material.

The first and second side frame members include elongate slots 46, 48, respectively, which are formed in vertical portions of the side frame members near front edges of the frame members. The elongate slots 46, 48 are provided to secure the power module to the frame 12. The modular locking switches 22a, 22b are provided to allow the operator to release the power module, with detents of the modular locking switches being configured to extend through the elongate slots 46, 48, respectively.

As shown, the end frame member 44 includes three pairs of busbars (power distribution elements), indicated at 50a, 50b, 52a, 52b, 54a, 54b. The three pairs of busbars 50a, 50b, 52a, 52b, 54a, 54b provide three phases of power, L1, L2, L3, with a first busbar of each pair, e.g., busbars 50a, 52a, 54a providing power in and a second busbar of each pair, e.g., busbars 50b, 52b, 54b providing power out. In the shown embodiment, the end frame member 44 is formed (with openings) to enable the busbars 50a, 50b, 52a, 52b, 54a, 54b to extend through the end frame member. Since the end frame member 44 is fabricated from an insulating material, e.g., epoxy, the busbars 50a, 50b, 52a, 52b, 54a, 54b are insulated from the first and second side frame members 40, 42. The end frame member 44 further provides a mechanical end stop for the power module when the power module is installed on the frame 12.

Referring to FIG. 4, the outside casing 14 functions as a tray and is installed on the frame 12. As shown, the outside casing 14 includes a bottom wall 60 and two side walls 62, 64 that extend along opposite edges of the bottom wall. When installed, a first side wall 62 is positioned next to the first side frame member 40 and the second side wall 62 is positioned next to the second side frame member 42. Similar to the first and second side frame members 40, 42, the first and second side wall 60, 62 include elongate slots 66, 68, respectively, which are formed in the side walls near front edges of the side walls. The elongate slots 66, 68 are aligned with the elongate slots 40, 42 formed in the first and second side frame members 40, 42, respectively. As described above with respect to the frame members 40, 42, the elongate slots 66, 68 are provided to secure the power module to the frame 12 with the modular locking switches 22a, 22b. FIG. 4 further illustrates the modular locking switches 22a, 22b provided on respective side walls 62, 64 of the outside casing 14.

The bottom wall 60 of the outside casing 14 further includes several guide pins, each indicated at 70. Each guide pin 70 extends in an upward direction from the bottom wall 60 of the outside casing 14. In the shown embodiment, there are six guide pins 70 arranged in two rows, each having three guide pins. The locations of the guide pins 70 can be arranged as desired. The purpose of the guide pins 70 will become apparent as the description of the backfeed protection system 10 proceeds.

The outside casing 14 further includes a mounting bracket 72, sometimes referred to as the first bracket, to secure the linear motor 18 to the outside casing. As shown, the mounting bracket 72 is secured to the bottom wall 60 of the outside casing 14. The mounting bracket 72 further provides a release point for manual release of the outside casing and the module from the backfeed protection system 10 as will be described in greater detail below.

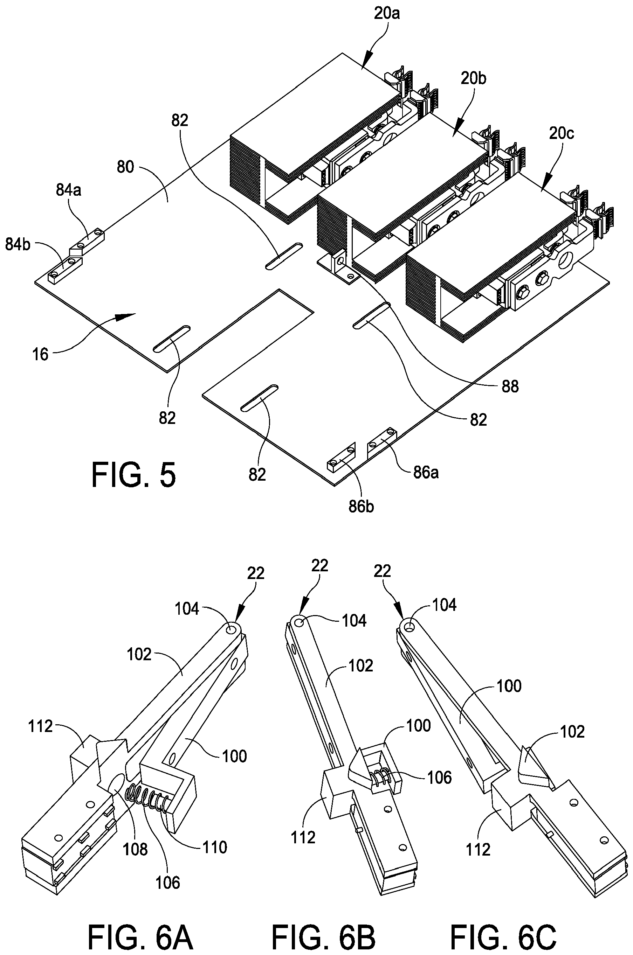

Referring to FIG. 5, the moving plate assembly 16 includes a moving plate 80 and three thyristor assemblies 20a, 20b, 20c, which are secured to the moving plate. The moving plate 80 is configured to be installed on the outside casing 14 and move relative to the outside casing. As shown, the moving plate 80 includes slide openings, each indicated at 82, which are sized to receive the guide pins 70 of the outside casing 14 to limit movement of the moving plate with respect to the outside casing. Specifically, when installing the moving plate assembly 16 on the outside casing 14, lateral edges of the moving plate 80 are positioned within the side walls 62, 64 of the outside casing, with the guide pins 70 being inserted into respective slide openings 82. Once installed, the moving plate assembly 16 is configured to slide back and forth with respect to the outside casing 14 to move the thyrsistor assemblies 20a, 20b, 20c toward and away from the busbars 50a, 50b, 52a, 52b, 54a, 54b of the frame 12.

The moving plate 80 further includes several guides, 84a, 84b, 86a, 86b, to control the position of the modular locking switches 22a, 22b on the moving plate. As shown, there are two guides 84a, 84b provided on one side of the moving plate 80 adjacent to a lateral edge of the moving plate and two guides 86a, 86b provided on the other side of the moving plate adjacent to an opposite lateral edge of the moving plate. The manner in which the guides 84a, 84b, 86a, 86b interact with the modular locking switches 22a, 22b will be described in greater detail below.

The thyrister assemblies 20a, 20b, 20c are mounted along a back edge of moving plate 80 so that jaws of the thyristor assemblies extend toward the back of the moving plate. Another mounting bracket 88, sometimes referred to as the second bracket, is secured to the moving plate 80 just behind the middle thyristor assembly 20b. The mounting bracket 88 is aligned with the mounting bracket 72 of the outside casing 14. As will be described in greater detail below, the mounting brackets 72, 88 are configured to secure the linear motor 18, which is provided to move the moving plate assembly 16 with respect to the outside casing 14.

Referring to FIGS. 6A-6C, and particularly to FIG. 6A, the modular locking switch, indicated at 22, includes a base element 100 that is fixedly secured to the outside casing 14 and a moving arm 102 that is hingedly secured to the base element. As shown, the base element 100 and the moving arm are secured to one another by hinge 104. The modular locking switch 22 further includes a spring 106 to bias the moving arm 102 away from the base element 100. The moving arm 102 includes a recess 108 to receive one end of the spring 106 and the base element 100 includes a pin 110 to position the opposite end of the spring. The moving arm 102 includes a locking pawl or detent 112 that is positioned to extend through the elongate slots 46, 48 of the frame members 40, 42 of the frame 12 and the elongate slots 66, 68 of the outside casing 14 when the elongate slots are aligned with one another. In this position, the outside casing 14 is secured to the frame 12. FIG. 6B illustrates the modular locking switch 22 in a locked position in which the power module is engaged. FIG. 6C illustrates the modular locking switch 22 in an unlocked position in which the power module is disengaged and can be removed from the frame 12.

In one embodiment, the moving arm 102 of the modular locking switch 22 can include a position switch to sense the position of the modular locking switch, i.e., whether the modular locking switch is in a locked position or an unlocked position.

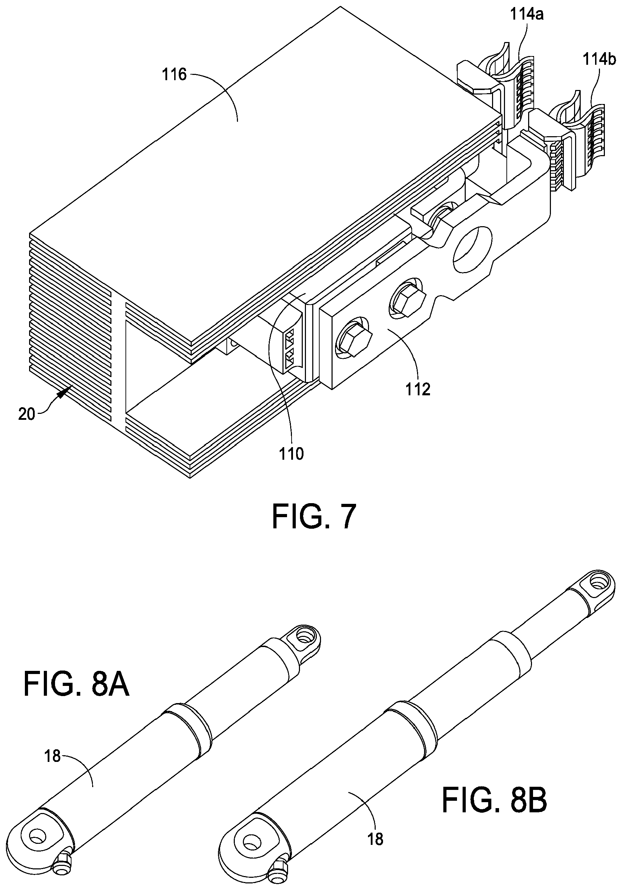

Referring to FIG. 7, the thyristor assembly, indicated at 20, includes a thyristor 110, two busbars secured to the thyristor (one busbar 112 shown) and two jaws 114a, 114b secured to respective busbars. The thyristor assembly 20 further includes a relatively large heat sink 116 that is secured to the thyristor 110 and provided to dissipate heat from the thyristor. The heat sink 116 is configured to be secured to the moving plate 80 of the moving plate assembly 16. When the thyristor assembly 20 is secured to the moving plate 80, the jaws 114a, 114b of the thyristor assembly are aligned with respective busbars, e.g., busbars 50a, 50b, of the frame 12 to provide electrical connection between the busbars and the thyristor assembly.

Referring to FIGS. 8A and 8B, the linear motor 18 is shown in a retracted position (FIG. 8A) and an extended position (FIG. 8B). The linear motor 18 includes a position sensor located with a body of the linear motor to provide a signal to a controller on the position of the linear motor. As described above, the linear motor 18, which may be referred to as an actuator, is secured to the bottom wall 60 of the outside casing 14 by the mounting bracket 72 and to the moving plate 80 of the moving plate assembly 16 by the mounting bracket 88.

The backfeed protection system 10 of embodiments of the present disclosure is designed for three "normal" modes of operation and two "abnormal" modes of operation (refer to drawing figures below). The modes of operation are as follows:
1. "Replace position" - Operator can insert or extract the power module.
2. "Backfeed protection and ready to engage position" - Operator is prevented from extracting the power module and the power module is not operational.
3. "Engaged position" - The power module is operational.
4. "Motor jammed" - Backup approach to remove the power module from frame.
5. "Prevent insert in prohibited position" - A mechanism is provided to prevent unwanted full insertion of the power module.

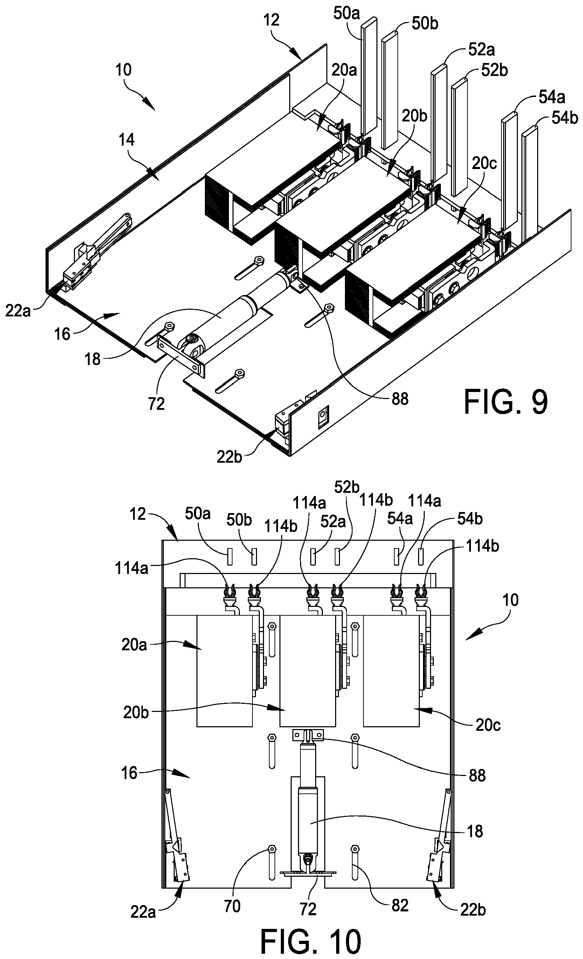

Referring to FIGS. 9 and 10, in the replace position, the power module, which includes the outside casing 14 and the moving plate assembly 16, engages the end stops of the end frame member 44 of the frame 12 to indicate to the operator that the power module is inserted within the frame. In some examples, in the replace position, the power module, which includes the outside casing 14 and the moving plate assembly 16, engages the end stops of the end frame member 44 of the frame 12 to indicate to the operator that the power module is fully inserted within the frame. In some examples, in the replace position, the power module, which includes the outside casing 14 and the moving plate assembly 16, engages the end stops of the end frame member 44 of the frame 12 to indicate to the operator that the power module is at least partially inserted within the frame.In this replace position, the jaws 114a, 114b of the thyristor assemblies 20a, 20b, 20c are spaced from the busbars 50a, 50b, 52a, 52b, 54a, 54b and the linear motor 18 is in the retracted position. Stated another way, in the replace position, the jaws 114a, 114b of the thyristor assemblies 20a, 20b, 20c are disengaged from the busbars 50a, 50b, 52a, 52b, 54a, 54b. As shown, the modular locking switches 22a, 22b are forced open by the position guides 84a, 84b, 86a, 86b provided on the moving plate 80 of the moving plate assembly 16. In the replace position, the operator can service the power module, including removing the power module from the frame 12.

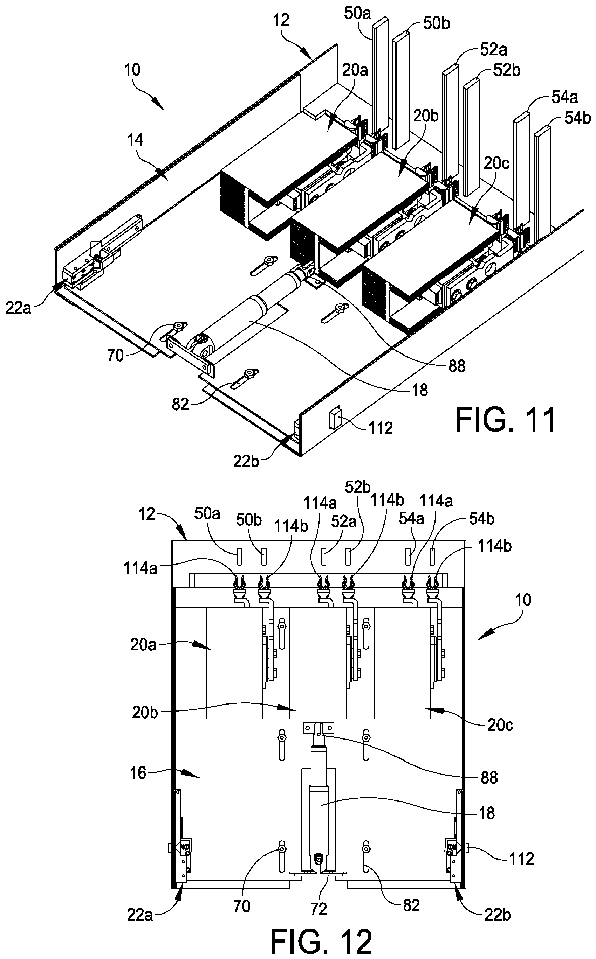

Referring to FIGS. 11 and 12, in the ready position, the power module maintains its engagement with the end stops of the end frame member 44 of the frame 12 to indicate to the operator that the power module is inserted within the frame. In some examples, in the ready position, the power module maintains its engagement with the end stops of the end frame member 44 of the frame 12 to indicate to the operator that the power module is inserted fully within the frame. In some examples, in the ready position, the power module maintains its engagement with the end stops of the end frame member 44 of the frame 12 to indicate to the operator that the power module is at least partially inserted within the frame.In this ready position, the jaws 114a, 114b of the thyristor assemblies 20a, 20b, 20c are spaced from the busbars 50a, 50b, 52a, 52b, 54a, 54b a clearance distance as required by industry standard. The linear motor 18 is extended a predetermined distance from the retracted position to achieve the clearance distance of the jaws 114a, 114b from the busbars 50a, 50b, 52a, 52b, 54a, 54b. As shown, the modular locking switches 22a, 22b are closed, with the springs 106 forcing the moving arms 102 to position the detents 112 within the elongate slots 46, 48 of the side frame members 40, 42 of the frame 12 and the elongate slots 66, 68 of the side walls 62, 64 of the outside casing 14, respectively. In the ready position, the jaws 114a, 114b of the thyristor assemblies 20a, 20b, 20c are still disengaged from the busbars 50a, 50b, 52a, 52b, 54a, 54b but ready to be extended toward the busbars.

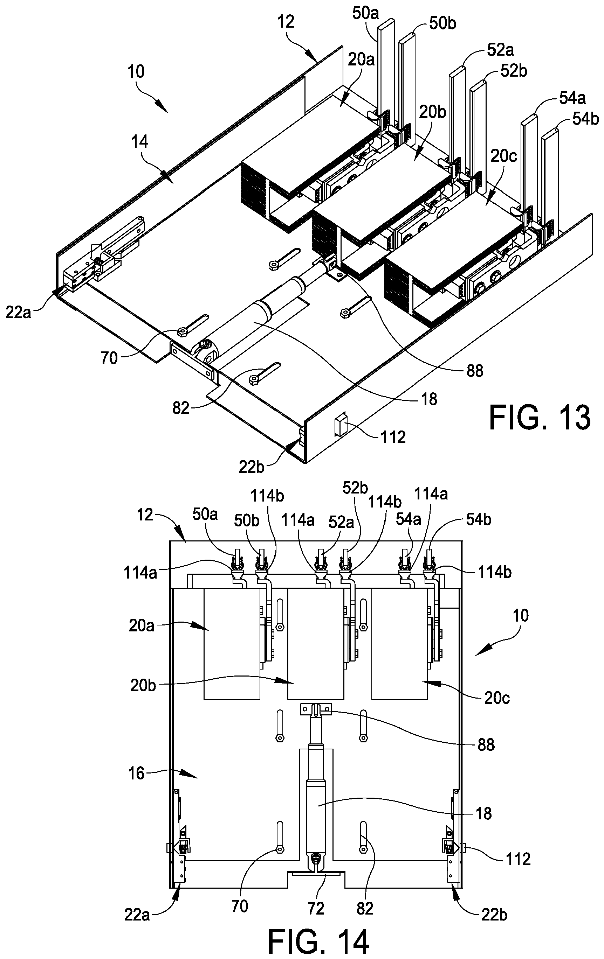

Referring to FIGS. 13 and 14, in the engaged position, the power module maintains its engagement with the end stops of the end frame member 44 of the frame 12 and the jaws 114a, 114b of the thyristor assemblies 20a, 20b, 20c are extended to engage the busbars 50a, 50b, 52a, 52b, 54a, 54b. The jaws 114a, 114b of the thyristor assemblies 20a, 20b, 20c are extended by operating the linear motor 18 to its extended position with the jaws of the thyristor assemblies engaged with the busbars 50a, 50b, 52a, 52b, 54a, 54b. The guides 84a, 84b, 86a, 86b of the moving plate 80 of the moving plate assembly 16 are configured to lock the moving plate assembly in position. The modular locking switches 22a, 22b are closed, with the springs 106 forcing the moving arms 102 to position the detents 112 within the elongate slots 46, 48 of the side frame members 40, 42 of the frame 12 and the elongate slots 66, 68 of the side walls 62, 64 of the outside casing 14, respectively. In the engaged position, the power module is operation and electrically engaged with the busbars 50a, 50b, 52a, 52b, 54a, 54b.

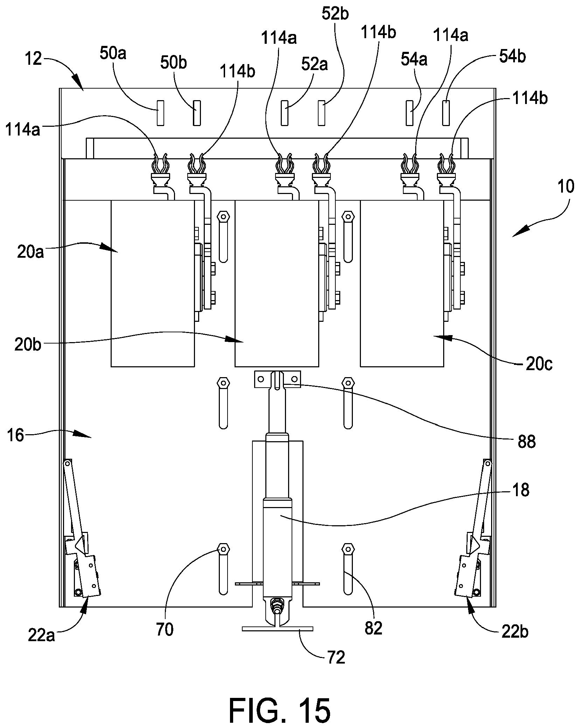

Referring to FIG. 15, if the linear motor 18 is jammed or otherwise disabled, the backfeed protection system 10 is configured to lock the power module so the power module cannot be removed. To overcome the issue of having a locked power module, another approach may be implemented to release the mechanism to remove the power module. In one embodiment, the mounting bracket 72 connecting the linear motor 18 to the bottom wall 60 of the outside casing 14 can be removed by loosening screws that secure the mounting bracket to the outside casing. Using this other approach may require the entire system to be de-energized for safety reasons.

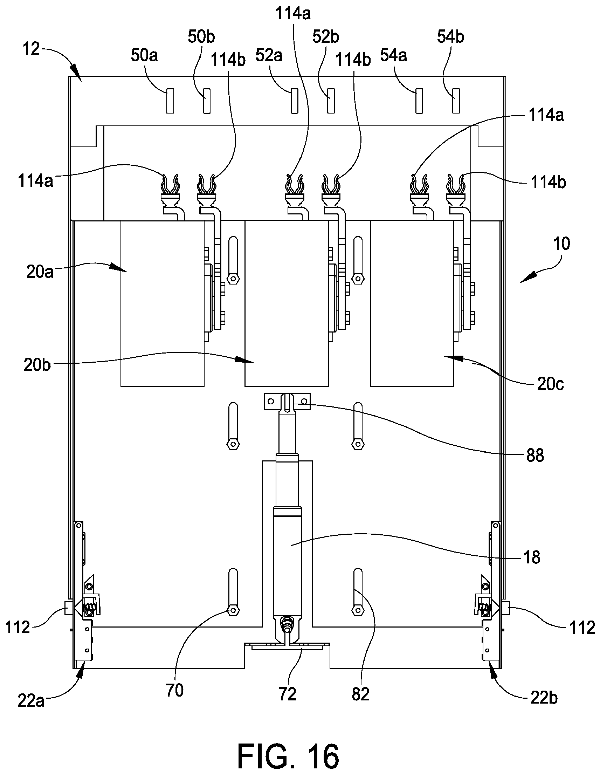

Referring to FIG. 16, another unlikely issue is if jaws 114a, 114b of the thyristor assemblies 20a, 20b, 20c come into contact with energized busbars 50a, 50b, 52a, 52b, 54a, 54b as the power module is inserted onto the frame 12 by the operator. This could happen if the linear motor 18 is in the most outward or extended position (for whatever reason).

To overcome this issue, the modular locking switches 22a, 22b are each configured with the pawl 112 in a way to prevent insertion of the power module. Further, the modular locking switches 22a, 22b operate with guides 84a, 84b and guides 86a, 86b, respectively, to prevent this feature from being bypassed as the result of a potential misuse (attempting to push in the pawl 112 with a hand).

In some embodiments, the use of a linear motor is provided to deliver a backfeed protection capability.

In some embodiments, a static bypass module is inserted into and released from by means of a plate arrangement configured to secure components in the module and to provide transversal front/back movement. A linear motor is configured to drive the transversal front/back movement. The combination of the linear motor and the modular locking switches control the transition between the three "normal" states and the two "abnormal" states.

A method of selectively engaging electrical contacts, e.g., jaws of the thyristor assembly, to a frame, e.g., busbars, includes supporting the electrical contacts with a moving plate assembly and positioning the moving plate assembly on an outside casing, which is coupled to the frame. The method further includes moving the moving plate assembly with respect to the outside casing between an engaged position in which the electrical contacts are engaged with the frame and a disengaged position in which the electrical contacts are disengaged from the frame.

In some embodiments, a linear actuator is provided to move the moving plate assembly with respect to the outside casing.

In some embodiments, the method further includes preventing removal of the outside casing from the frame with a switch coupled to the outside casing and the frame and configured to prevent a removal of the outside casing from the frame when the moving plate assembly is not in the disengaged position. The switch is configured to lock the outside casing to the frame when moving the moving plate assembly from the disengaged position to a ready position prior to the engaged position. The switch includes a detent positioned to extend through an opening of the outside casing and an aligned opening of the frame when moving the moving plate assembly from the disengaged position to the ready position to lock the outside casing in place with respect to the frame.

In some embodiments, the method further includes guiding the movement of the switch when moving the moving plate assembly from the disengaged position to the ready position to release the detent from the openings of the outside casing and the frame.

In some embodiments, the method further includes guiding the movement of the moving plate assembly with respect to the outside casing.

In some embodiments, the backfeed protection system can be used with other types of connectors. For example, the jaws and busbars may be replaced with plug-and-socket type connectors and blind mate connectors.

Various controllers may execute various operations discussed above. Using data stored in associated memory and/or storage, the controller also executes one or more instructions stored on one or more non-transitory computer-readable media, which the controller may include and/or be coupled to, that may result in manipulated data. In some examples, the controller may include one or more processors or other types of controllers. In one example, the controller is or includes at least one processor. In another example, the controller performs at least a portion of the operations discussed above using an application-specific integrated circuit tailored to perform particular operations in addition to, or in lieu of, a general-purpose processor. As illustrated by these examples, examples in accordance with the present disclosure may perform the operations described herein using many specific combinations of hardware and software and the disclosure is not limited to any particular combination of hardware and software components. Examples of the disclosure may include a computer-program product configured to execute methods, processes, and/or operations discussed above. The computer-program product may be, or include, one or more controllers and/or processors configured to execute instructions to perform methods, processes, and/or operations discussed above.

Further examples are provided in the following clauses.
Clause 1. A backfeed protection system, comprising:
   a casing;
   a moving plate assembly supported by the casing and configured to move with respect to the casing, the moving plate assembly including at least one electrical contact configured to releasably engage a power distribution element; and
   an actuator secured to the casing and the moving plate assembly, the actuator being configured to move the moving plate assembly with respect to the casing between an engaged position in which the at least one electrical contact is engaged with the power distribution element and a disengaged position in which the at least one electrical contact is disengaged from the power distribution unit.
Clause 2. The backfeed protection system of clause 1, further comprising at least one switch coupled to the casing and configured to prevent a removal of the casing when the moving plate assembly is in at least one of a ready position or the disengaged position.
Clause 3. The backfeed protection system of clause 2, wherein the at least one switch is configured to lock the casing to a frame when moving the moving plate assembly from the disengaged position to the ready position prior to the engaged position.
Clause 4. The backfeed protection system of clause 3, wherein the at least one switch includes a detent positioned to extend through an opening of the casing and an aligned opening of the frame when moving the moving plate assembly from the disengaged position to the ready position to lock the casing in place with respect to the frame.
Clause 5. The backfeed protection system of clause 4, wherein the moving plate assembly includes a guide configured to guide the movement of the switch when moving the moving plate assembly from the disengaged position to the ready position to release the detent from the openings of the casing and the frame.
Clause 6. The backfeed protection system of clause 2, wherein the at least one switch includes a moving arm, a base element pivotally secured to the moving arm, a spring to bias the base element away from the moving arm, and a position switch configured to sense a position of the moving arm.
Clause 7. The backfeed protection system of clause 6, wherein the moving plate assembly includes a guide configured to guide movement of the base element when moving the moving plate assembly from the disengaged position to a ready position to move the moving arm from an unlocked position to a locked position.
Clause 8. The backfeed protection system of clause 1, wherein the power distribution element includes a busbar.
Clause 9. The backfeed protection system of clause 8, wherein the at least one electrical contact includes a jaw configured to engage the busbar.
Clause 10. The backfeed protection system of clause 9, wherein the moving plate assembly includes at least one thyristor assembly having the at least one electrical contact.
Clause 11. The backfeed protection system of clause 1, wherein the actuator includes a linear motor secured to the casing by a first bracket and to a moving plate of the moving plate assembly by a second bracket.
Clause 12. The backfeed protection system of clause 1, wherein the casing includes a bottom wall having at least one guide pin, and wherein the moving plate assembly includes a moving plate having at least one slot configured to receive the at least one guide pin configured to extend through the at least one slot to guide movement of the moving plate assembly with respect to the casing.
Clause 13. A method of selectively engaging at least one electrical contact to a power distribution element, the method comprising:
   supporting the at least one electrical contact with a moving plate assembly;
   positioning the moving plate assembly on a casing; and
   moving the moving plate assembly with respect to the casing between an engaged position in which the at least one electrical contact is engaged with the power distribution element and a disengaged position in which the at least one electrical contact is disengaged from the power distribution element.
Clause 14. The method of clause 13, wherein moving the moving plate assembly with respect to the casing is achieved by an actuator secured to the casing and to a moving plate of the moving plate assembly.
Clause 15. The method of clause 13, further comprising preventing removal of the casing from the frame with at least one switch coupled to the casing and configured to prevent a removal of the casing when the moving plate assembly is in at least one of a ready position or the disengaged position.
Clause 16. The method of clause 15, wherein the at least one switch is configured to lock the casing to the frame when moving the moving plate assembly from the disengaged position to the ready position prior to the engaged position.
Clause 17. The method of clause 16, wherein the at least one switch includes a detent positioned to extend through an opening of the casing and an aligned opening of the frame when moving the moving plate assembly from the disengaged position to the ready position to lock the casing in place with respect to the frame.
Clause 18. The method of clause 17, further comprising guiding the movement of the switch when moving the moving plate assembly from the disengaged position to the ready position to release the detent from the openings of the casing and the frame.
Clause 19. The method of clause 13, wherein the power distribution element includes a busbar, and wherein the at least one electrical contact includes a jaw configured to engage the busbar.
Clause 20. The method of clause 13, further comprising guiding the movement of the moving plate assembly with respect to the casing.

Having thus described several aspects of at least one embodiment, it is to be appreciated various alterations, modifications, and improvements will readily occur to those skilled in the art. Such alterations, modifications, and improvements are intended to be part of this disclosure and are intended to be within the scope of the disclosure. Accordingly, the foregoing description and drawings are by way of example only.

## Claims

1. A backfeed protection system, comprising:
a casing;
a moving plate assembly supported by the casing and configured to move with respect to the casing, the moving plate assembly including at least one electrical contact configured to releasably engage a power distribution element; and
an actuator secured to the casing and the moving plate assembly, the actuator being configured to move the moving plate assembly with respect to the casing between an engaged position in which the at least one electrical contact is engaged with the power distribution element and a disengaged position in which the at least one electrical contact is disengaged from the power distribution unit.

2. The backfeed protection system of claim 1, further comprising at least one switch coupled to the casing and configured to prevent a removal of the casing when the moving plate assembly is in at least one of a ready position or the disengaged position.

3. The backfeed protection system of claim 2, wherein the at least one switch is configured to one or more of
- locking the casing to a frame when moving the moving plate assembly from the disengaged position to the ready position prior to the engaged position; and
- including a moving arm, a base element pivotally secured to the moving arm, a spring to bias the base element away from the moving arm, and a position switch configured to sense a position of the moving arm.

4. The backfeed protection system of claim 3, wherein the at least one switch includes a detent positioned to extend through an opening of the casing and an aligned opening of the frame when moving the moving plate assembly from the disengaged position to the ready position to lock the casing in place with respect to the frame.

5. The backfeed protection system of claim 4, wherein the moving plate assembly includes a guide configured to guide the movement of the switch when moving the moving plate assembly from the disengaged position to the ready position to release the detent from the openings of the casing and the frame.

6. The backfeed protection system of claim 3, wherein the moving plate assembly includes a guide configured to guide movement of the base element when moving the moving plate assembly from the disengaged position to a ready position to move the moving arm from an unlocked position to a locked position.

7. The backfeed protection system of any of the above claims, wherein the power distribution element includes a busbar, and wherein the at least one electrical contact includes a jaw configured to engage the busbar.

8. The backfeed protection system of claim 7, wherein the moving plate assembly includes at least one thyristor assembly having the at least one electrical contact.

9. The backfeed protection system of any of the above claims, wherein the actuator includes a linear motor secured to the casing by a first bracket and to a moving plate of the moving plate assembly by a second bracket.

10. The backfeed protection system of any of the above claims, wherein the casing includes a bottom wall having at least one guide pin, and wherein the moving plate assembly includes a moving plate having at least one slot configured to receive the at least one guide pin configured to extend through the at least one slot to guide movement of the moving plate assembly with respect to the casing.

11. A method of selectively engaging at least one electrical contact to a power distribution element, the method comprising:
supporting the at least one electrical contact with a moving plate assembly;
positioning the moving plate assembly on a casing; and
moving the moving plate assembly with respect to the casing between an engaged position in which the at least one electrical contact is engaged with the power distribution element and a disengaged position in which the at least one electrical contact is disengaged from the power distribution element.

12. The method of claim 11, wherein moving the moving plate assembly with respect to the casing is achieved by an actuator secured to the casing and to a moving plate of the moving plate assembly.

13. The method of claim 11, further comprising preventing removal of the casing from the frame with at least one switch coupled to the casing and configured to prevent a removal of the casing when the moving plate assembly is in at least one of a ready position or the disengaged position.

14. The method of claim 13,
wherein the at least one switch includes a detent positioned to extend through an opening of the casing and an aligned opening of the frame when moving the moving plate assembly from the disengaged position to the ready position to lock the casing in place with respect to the frame;
wherein the at least one switch is configured to lock the casing to a frame when moving the moving plate assembly from the disengaged position to the ready position prior to the engaged position;
the method further comprising guiding the movement of the switch when moving the moving plate assembly from the disengaged position to the ready position to release the detent from the openings of the casing and the frame.

15. The method of any of the claims 11 to 14, further comprising guiding the movement of the moving plate assembly with respect to the casing.
